# DEMANDE DE BREVET EUROPEEN

(11) **EP 0 771 009 A1**
(43) Date de publication de la demande: **02.05.1997**
(21) Numéro de dépôt: 96402231.3
(22) Date de dépôt: 18.10.1996
(51) Int. Cl.: H01B 3/08, H01B 3/00, H01B 19/00, H05K 1/03

(54) **Support à constante diélectrique faible, application à une plaque de circuits imprimés et procédé de réalisation**

(30) Priorité: 27.10.1995 FR 9512715
(71) Demandeur: THOMSON-CSF, 75008 Paris (FR)
(72) Inventeur: Garnot, Charles, Thomson-CSF, SCPI, 92402 Courbevoie Cedex (FR); Laforet, Serge, Thomson-CSF, SCPI, 92402 Courbevoie Cedex (FR)

(57) **Abrégé**

L'invention concerne un support à constante diélectrique faible comprenant un matériau à base de résine incorporant des portions de fibres de verre ainsi que des bulles de gaz réparties dans la résine.

On obtient un substrat à constante diélectrique faible, de bonne isotropie des caractéristiques et de faible densité.

Application : Plaques de circuits imprimés.

## Description

L'invention concerne un support à constante diélectrique faible et plus particulièrement une plaque de circuits imprimés et son procédé de réalisation.

Dans les techniques des circuits imprimés, les plaques utilisées sont souvent à base de composites fibres de verre/matériaux plastiques ou fibres de verre/Téflon. Les composites fibres de verre/Téflon sont utilisés dans les techniques hyperfréquences. Leurs constantes diélectriques vont de 2,2 à 3,2 environ.

Ces plaques sont réalisées par stratification de tissus de fibres de verre, voire de toiles en fibres de verre, et elles présentent une forte anisotropie. Par exemple : αₓ = α_{y} = 20 ppm/°C et α_{z} = 250 ppm/°C. Leur densité peut atteindre 2,2.

Pour diminuer la constante diélectrique, on utilise des plaques à base de Téflon et on augmente le taux de Téflon, mais cela contribue à augmenter le coefficient de dilatation ce qui est un inconvénient.

On constate que les substrats à coefficient diélectrique faible posent un problème d'anisotropie, de poids et éventuellement de dilatation thermique.

L'invention permet d'obtenir un substrat présentant :
- une constante diélectrique faible (voisine de 2,5 par exemple) ;
- une bonne isotropie de ses caractéristiques ;
- une faible densité (voisine de 1 par exemple) ;
- un faible coefficient de dilatation.

L'invention concerne donc un support à constante diélectrique faible, caractérisé en ce qu'il comprend un matériau à base de résine incorporant des portions de fibres de verre ainsi que des bulles de gaz réparties dans la résine.

L'invention est applicable à la réalisation de plaques de circuits imprimés mais également à la réalisation de tout matériau permettant d'être appliqué dans tout boîtier ou capot de protection et nécessitant une surface présentant un coefficient diélectrique faible.

L'invention concerne également un procédé de réalisation d'un support, caractérisé en ce qu'il comporte :
- une étape de mélange de granulés en résine incorporant des portions de fibres de verre, avec un agent émulsifiant ;
- une étape de chauffage du mélange obtenu jusqu'à la fusion des granulés en résine et piégage de bulles d'air ou de gaz ;
- une étape d'injection dans un moule du mélange fondu contenant le gaz provenant de l'émulsifiant ;
- une étape de refroidissement et de démoulage.

Les différents objets et caractéristiques de l'invention apparaîtront plus clairement dans la description qui va suivre et dans les figures annexées qui représentent:
- la figure 1, un exemple de réalisation d'un support selon l'invention ;
- la figure 2, un appareil de mise en oeuvre du procédé selon l'invention.

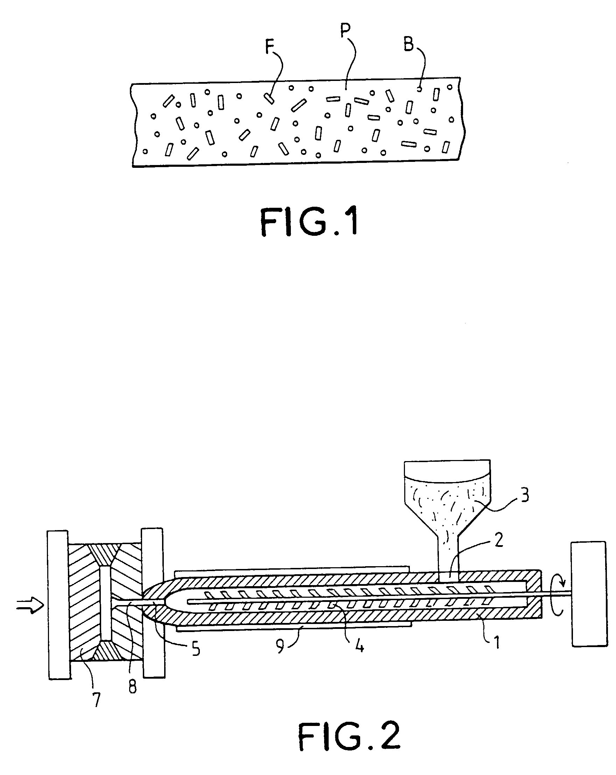

En se reportant à la figure 1, on va donc décrire un support diélectrique selon l'invention. Le substrat diélectrique représenté comporte une matrice en matériau plastique P incorporant des portions de fibres F et des bulles d'air ou de gaz B.

Le matériau plastique peut être réalisé à partir d'une résine thermoplastique ou thermodurcissable tel que par exemple du PolyPhénylèneOxyde (PPO).

Les portions de fibres sont par exemple des portions de fibres de verre de quelques dizaines de micromètres de diamètres de quelques millimètres de longueur (2 à 3 mm).

Les fibres sont réparties dans le matériau selon différentes directions aléatoires ce qui confère au matériau une isotropie tant des caractéristiques mécaniques que des caractéristiques électriques (coefficient diélectrique).

Un tel substrat se prête bien à la réalisation de plaques de circuits imprimés notamment dans les utilisations pour les circuits hyperfréquences.

Avec une proportion de :
10 à 30 % en masse de fibres
et 30 à 50 % en volume de bulles d'air
on peut obtenir des constantes diélectriques inférieures à 2,5 et le matériau a une densité nettement inférieure à 1,8.

Un tel substrat possède une densité plus faible en raison des bulles d'air ou de gaz incorporé. Il possède une bonne isotropie des caractéristiques et son coefficient de dilatation est faible (celui du matériau plastique P).

Un tel substrat pourrait être utilisé également pour des boîtiers de composant ou des capots de matériels nécessitant une permittivité électrique faible.

On va maintenant décrire un exemple de procédé de réalisation d'un substrat tel que celui de la figure 1.

Selon ce procédé, on utilise des granulés de résine contenant des portions de fibres de verre. Cette résine est de préférence une résine thermoplastique telle que du PolyPhénylèneOxyde (PPO). Comme décrit précédemment, les portions de fibres de verre ont par exemple 2 à 3 mm de longueur et quelques dizaines de microns de diamètre.

Ces granulés sont mélangés avec un agent émulsifiant. Cet agent peut se présenter sous forme également de granulés tels que des granulés connus dans le commerce sous le nom de "Génitron AF 100".

Les granulés de résine et l'agent émulsifiant sont mélangés de façon homogène. L'ensemble est chauffé jusqu'à atteindre la température de fusion des granulés de résines (par exemple température comprise entre 280 et 350 °C). Lors de cet échauffement, des bulles d'air (ou de gaz) sont piégées dans le milieu composite résine/émulsifiant. Le mélange ainsi obtenu est alors injecté dans un moule ayant la forme du substrat à obtenir. Après refroidissement, les bulles d'air sont piégées dans le mélange. Le substrat est alors démoulé.

La figure 2 représente une presse d'injection permettant de mettre en oeuvre le procédé précédent.

Elle comporte un corps 1 possédant une entrée 2 munie d'un réservoir d'alimentation 3 dans lequel est placé le mélange de résine et d'émulsifiant. Le corps 1 comporte par ailleurs une sortie 5 qui est destinée à être plaquée contre un orifice d'entrée d'un moule 7 dans lequel sera moulé le substrat. Une vis 10, du type vis d'archimède, est placée dans le corps 1. Elle permet, lorsqu'elle tourne, de transférer la résine et l'émulsifiant (qui est alimentée par le réservoir 3) de l'entrée 2 vers la sortie 5.

Enfin un système de chauffage 9 chauffe l'intérieur du corps 1 de façon à fondre la résine lors de son transfert dans le tube. La presse d'injection injecte dans le moule 7, un mélange fondu de résine et de fibres incorporant des bulles de gaz.

## Revendications

1. Support à constante diélectrique faible, caractérisé en ce qu'il comprend un matériau à base de résine incorporant des portions de fibres de verre de quelques mm de longueur ainsi que des bulles de gaz réparties dans la résine.

2. Support selon la revendication 1, caractérisé en ce que la résine est une résine thermoplastique ou thermodurcissable.

3. Support selon la revendication 2, caractérisé en ce que la résine est du polyphénylène oxyde (PPO).

4. Support selon la revendication 1, caractérisé en ce que les portions de fibres ont 2 à 3 mm de longueur et quelques dizaines de micromètres de diamètre.

5. Support selon l'une des revendications 1 à 4, caractérisé en ce qu'elle constitue une plaque de circuits imprimés.

6. Procédé de réalisation d'un support selon l'une des revendications précédentes, caractérisé en ce qu'il comporte :
- une étape de mélange de granulés en résine incorporant des portions de fibres de verre, avec un agent émulsifiant ;
- une étape de chauffage du mélange obtenu jusqu'à la fusion des granulés en résine et piégage de bulles d'air ou de gaz ;
- une étape d'injection dans un moule du mélange fondu ;
- une étape de refroidissement et de démoulage.

7. Procédé selon la revendication 6, caractérisé en ce que la température de chauffage est située entre 280 et 350 °C.
